# FASCICULE DE BREVET EUROPEEN

(11) **EP 0 771 030 B1**
(45) Date de publication et mention de la délivrance du brevet: **24.06.1998**
(21) Numéro de dépôt: 96402271.9
(22) Date de dépôt: 24.10.1996
(51) Int. Cl.: H01L 23/58

(54) **Procédé de détection de présence de passivation dans un circuit intégré**
Passivierungs-Detektionsverfahren für integrierte Schaltungen
Process for detecting the presence of a passivation over an integrated circuit

(30) Priorité: 26.10.1995 FR 9512659
(43) Date de publication de la demande: 02.05.1997
(73) Titulaire: SGS-THOMSON MICROELECTRONICS S.A., 94250 Gentilly (FR)
(72) Inventeur: Wuidart, Sylvie, 94230 Cachan (FR); Sourgen, Laurent, 94230 Cachan (FR)
(74) Mandataire: Schmit, Christian Norbert Marie

(56) Documents cités:
- EP-A- 0 169 941
- DE-A- 3 044 983

## Description

L'invention concerne un procédé pour détecter la présence de la couche diélectrique de passivation d'un circuit intégré. Elle concerne aussi un circuit muni d'un détecteur correspondant.

Dans un circuit intégré les couches actives sont habituellement recouvertes d'au moins une couche diélectrique de protection appelée couche de passivation. Cette couche a comme fonction première d'empêcher les pollutions d'altérer les caractéristiques électriques du circuit intégré. Des procédés divers sont utilisés pour réaliser cette couche qui permettent en outre d'obtenir une surface finale relativement plane.

En matière de protection des circuits intégrés contre toute tentative de fraude, cette couche de passivation permet par sa seule présence d'empêcher l'observation au microscope électronique des signaux internes statiques du circuit intégré. Cette couche isolante empêche aussi l'utilisation de pointes électroniques pour forcer l'état de signaux internes. Par ailleurs, il est connu d'utiliser un détecteur de présence de passivation, pour générer le cas échéant un signal d'alarme. Ce signal d'alarme peut bloquer le fonctionnement du circuit ou être envoyé vers un organe intelligent du circuit intégré. Des détecteurs de lumière (diodes) ont ainsi été utilisés. On a aussi utilisé le couplage capacitif de peignes de métal interdigités. En fonctionnement normal, quand on applique une impulsion d'entrée sur un peigne, on obtient en sortie sur l'autre peigne, une impulsion amplifiée. Cette amplification sert de base à la détection. Si on retire de la couche de passivation au-dessus des peignes, l'effet d'amplification est moindre, ce qui donne une impulsion en sortie atténuée. Le détecteur voit ce changement et génère une alarme.

Mais l'amélioration constante des techniques de retrait des couches permet presque aisément un retrait partiel de la couche de passivation sans déclencher d'alarme, malgré ces détecteurs.

Dans le cas du détecteur à peignes interdigités, on arrive aussi à court-circuiter les deux peignes et à appliquer un signal amplifié attendu sur la sortie, signal obtenu par simulation.

Il est donc devenu nécessaire de prévoir un détecteur qui puisse couvrir le maximum de surface du circuit intégré. Or on ne peut pas se permettre de multiplier purement et simplement les dispositifs connus, car les circuits électroniques nécessaires à la détection (comparateurs notamment) deviendraient trop encombrants.

Un objet de l'invention est un procédé de détection de présence de passivation qui permette une surveillance optimum de toute la surface du circuit intégré.

Un autre objet de l'invention est un circuit intégré comprenant un détecteur de présence de passivation particulièrement efficace.

Un autre objet de l'invention est un circuit intégré comprenant un détecteur de présence de passivation difficile à simuler.

Telle que revendiquée, l'invention concerne un procédé de détection de présence d'une couche diélectrique de passivation sur un circuit intégré. Selon l'invention, ce procédé consiste à émettre un train d'impulsions de largeurs différentes sur une extrémité d'une ligne de métal serpentant en surface du circuit intégré, sous la couche de passivation, à compter le nombre d'impulsions reçues sur l'autre extrémité de la ligne de métal et à comparer ce nombre à au moins une valeur de référence caractéristique du filtre formé par la ligne de métal et la couche de passivation.

Avantageusement, on prévoit de synchroniser l'émission et la réception par un générateur aléatoire d'un signal binaire.

L'invention concerne aussi un circuit intégré comprenant un détecteur de présence d'une couche diélectrique de passivation. Selon l'invention, le détecteur comprend une ligne de métal serpentant en surface du circuit intégré sous la couche de passivation, un émetteur d'un train d'impulsions de largeurs différentes sur une extrémité de la ligne de métal et un récepteur connecté à l'autre extrémité de la ligne de métal, ledit récepteur étant apte à compter le nombre d'impulsions reçues et à comparer ce nombre à au moins une valeur de référence caractéristique du filtre formé par la ligne de métal et la couche de passivation.

D'autres caractéristiques et avantages de l'invention sont détaillés dans la description suivante, faite à titre indicatif et nullement limitatif de l'invention, en référence aux dessins annexés, dans lesquels :
- la figure 1 représente un synoptique d'un circuit de détection selon l'invention;
- la figure 2 représente en fonction du temps les signaux émis et reçus selon le principe de détection de l'invention;
- la figure 3 représente un schéma détaillé d'un circuit intégré comprenant un circuit de détection selon l'invention et
- la figure 4 représente une vue en perspective d'un circuit intégré avec une ligne de métal serpentant en surface selon le principe de l'invention.

Un circuit de détection selon l'invention comprend un émetteur 1 qui envoie un train d'impulsions de largeurs différentes (signal Se) sur une extrémité 2ₐ d'une ligne de métal 2. Cette ligne de métal 2 serpente en surface du circuit intégré sous une couche de passivation. L'autre extrémité 2_{b} de la ligne de métal est connectée en entrée d'un récepteur 3.

L'émetteur comprend typiquement des circuits diviseurs d'une horloge de référence (au moins) et de circuits de synchronisation pour former le train d'impulsions.

La fonction du récepteur 3 est de compter le nombre d'impulsions reçues sur l'extrémité 2_{b}. A cet effet le récepteur pourra comprendre un circuit 4 de remise en forme des impulsions, typiquement un trigger de schmitt, connecté en sortie à un compteur 5. Le circuit de remise en forme reçoit un signal Sr de la ligne de métal et délivre au compteur un signal filtré Sf.

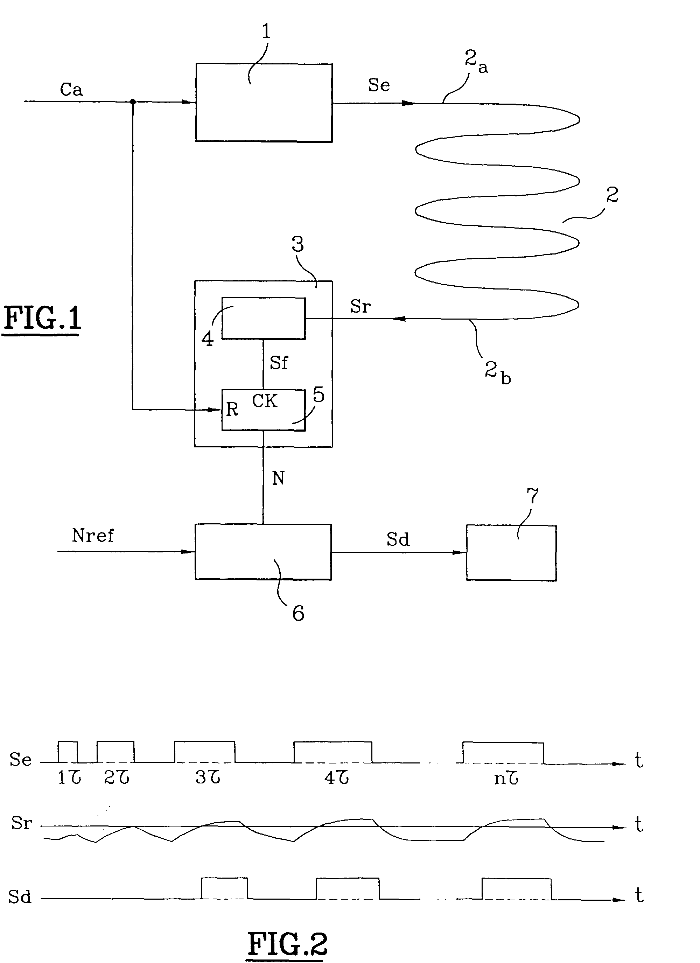

Les formes des signaux émis Se et reçu Sr sont représentées sur la figure 2.

La ligne de métal et la couche de passivation forment un filtre RC passe-bas. En émettant sur l'extrémité 2ₐ un train d'impulsions de largeurs différentes, on ne retrouvera en sortie que les impulsions dont la fréquence correspondante sera supérieure à la fréquence de coupure de ce filtre. Dans l'exemple de la figure 2, on utilise simplement un train d'impulsions de largeur croissante, multiple d'une largeur de référence τ. Et dans cet exemple le signal reçu montre des impulsions atténuées, dont les premières impulsions de largeur τ et 2τ ne seront pas détectées par le récepteur 3. Leur fréquence respective est supérieure à la fréquence de coupure du filtre.

Le signal remis en forme Sf est appliqué sur l'entrée d'horloge du compteur qui est incrémenté à chaque nouvelle impulsion. Il suffit alors de comparer le nombre compté N à une valeur de référence Nref pour délivrer un signal binaire Sd dont l'état "0" ou "1" indique si il y a ou non anomalie. Cette valeur Nref est calculée en sortie de fabrication, dans une routine de test du circuit, dans laquelle on fait envoyer le train d'impulsion par l'émetteur pour ensuite compter le nombre Nref d'impulsions reçues en sortie. Cette valeur Nref est ensuite programmée dans le circuit intégré dans un registre de mémoire non volatile et non effaçable.

Si le nombre compté N ne correspond pas à la valeur de référence Nref, cela veut dire que le filtre RC est modifié, c'est à dire que la couche de passivation a été enlevée ou détériorée et qu'il faut générer une alarme.

En général, on utilisera l'état actif du signal binaire Sd qui indique le résultat de la comparaison, pour déclencher le changement d'état d'un registre monostable 7. Ce registre peut par exemple être lu de temps en temps par le microprocesseur du circuit intégré dans ses routines de vérification ou encore générer une interruption vers le microprocesseur. Seul le microprocesseur peut remettre à zéro ce registre. On pourrait aussi utiliser ce signal Sd pour activer un circuit d'autodestruction d'un circuit intégré.

Pour effectuer la comparaison, on peut utiliser un comparateur 6, qui reçoit sur une entrée la valeur comptée N et sur une autre entrée la valeur de référence Nref.

La comparaison peut être aussi effectuée par un microprocesseur du circuit intégré. Dans ce cas, on prévoit que le résultat du compteur est transféré dans un registre qui est lu puis réinitialisé par le compteur par le microprocesseur pendant ses routines de vérification et que la valeur N lue est comparée à la valeur de référence Nref.

Pour synchroniser les différents éléments, on utilise un signal d'horloge Ca. Sa fréquence est fonction de la longueur du train d'impulsions que l'on veut émettre. Il est appliqué à l'émetteur pour lui faire envoyer une nouvelle fois le train d'impulsions. Il est appliqué au récepteur pour transférer le résultat vers le comparateur ou un registre (front montant) , puis pour réinitialiser le compteur (front descendant). Il est appliqué enfin, le cas échéant au comparateur pour effectuer la comparaison.

Compte-tenu des variations des paramètres de fonctionnement, comme la tension ou la température qui peuvent quelque peu modifier la réponse du filtre formé par la ligne de métal et la couche de passivation, les tests effectués en sortie de fabrication sont tels qu'ils permettent de mesurer l'impact sur la valeur Nref des différentes variations possibles. On arrive ainsi à définir un intervalle de tolérance, délimité donc par deux valeurs de référence Nref1 et Nref2. Si le nombre N compté est situé entre ces deux valeurs, le résultat peut être considéré comme correct. On prévoit donc avantageusement d'effectuer la comparaison à ces deux valeurs, pour éviter des alarmes intempestives, dues au bruit ou aux variations de paramètres de fonctionnement.

On peut en outre prévoir, lorsque le circuit intégré comprend un microprocesseur, d'effectuer un filtrage numérique des résultats, pour affiner encore la détection. Dans ce cas le microprocesseur effectuera par exemple lui-même la comparaison pour effectuer un lissage des résultats obtenus.

L'invention décrite permet de résoudre les différents problèmes précédemment évoqués. En effet, comme la ligne serpente sous la surface, il devient très difficile d'effectuer un retrait même partiel sans que les caractéristiques du filtre en soit affectées : des impulsions normalement trop courtes seront alors reçues et comptabilisées en sortie et le résultat de la ou des comparaisons sera faux. Si on coupe la ligne, on ne recevra plus rien en sortie. Enfin, si toutefois les obstacles précédents étaient toutefois surmontés, il faudrait encore pouvoir simuler le train d'impulsions attendus en sortie.

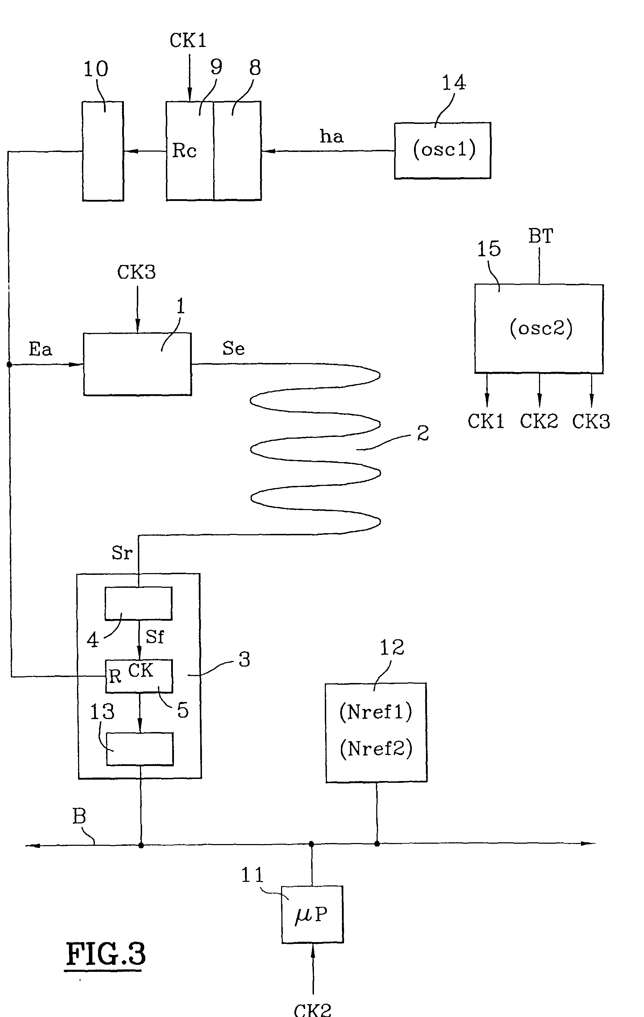

Dans un perfectionnement, pour rendre très complexe la détection, on prévoit encore l'utilisation d'un générateur pseudo-aléatoire pour générer l'impulsion de synchronisation Ca. C'est ce qui est représenté sur la figure 3. Un générateur 8 délivre une valeur aléatoire vers un compteur 9 qui décompte cette valeur jusqu'à zéro, à la cadence d'une horloge Ck1. Une sortie Rc (passage par zéro) du compteur change alors de niveau et ce changement d'état est détecté par un monostable 10 qui émet l'impulsion de synchronisation Ca. Le générateur est calibré pour que l'impulsion de synchronisation soit fournie à intervalles supérieurs à la longueur du train d'impulsions à émettre.

De préférence, ce générateur fonctionne avec sa propre horloge ha. Cette horloge peut elle même être rendue aléatoire en la faisant varier avec le bruit sur la température ou la tension d'alimentation du circuit. Les valeurs aléatoires générées par les registres à décalage du générateur peuvent aussi être ré-injectés dans le générateur.

On peut ainsi avoir (figure 3) dans le circuit intégré, un microprocesseur 11, une mémoire 12 non volatile non effaçable et un registre 13 en sortie du compteur 5 du récepteur 3. Ce microprocesseur, cette mémoire et ce registre sont dans l'exemple tous accessibles par un bus de données et d'adresse B. Les autres éléments du récepteur 3 (circuit de remise en forme 4, compteur 5), l'émetteur 1 et le circuit de génération de l'impulsion de synchronisation (8, 9, 10) sont eux inaccessibles par ce bus. Le circuit de génération de l'impulsion dispose d'un circuit 14 de génération de son horloge propre à partir d'un oscillateur osc1. Une base de temps 15 avec un autre oscillateur osc2 permet de générer les autres horloges nécessaires au circuit, notamment l'horloge Ck2 du microprocesseur et celle Ck3 (ou celles) nécessaire à l'émetteur 1 pour générer le train d'impulsions (signal Se).

Diverses structures différentes sont possibles et il ne s'agit ici que d'un exemple auquel ne se limite nullement l'invention telle que définie par les revendications.

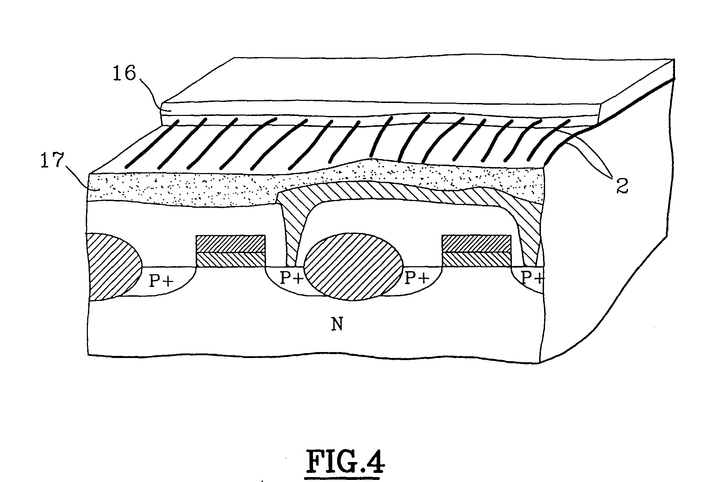

La figure 4 montre enfin en perspective un circuit intégré avec une ligne de métal 2 serpentant en surface sous la couche de passivation finale, 16. Sous la ligne de métal se trouve une couche d'isolant 17 et les couches dites actives du circuit intégré.

## Revendications

1. Procédé de détection de présence d'une couche diélectrique de passivation (16) sur un circuit intégré, consistant à émettre un train d'impulsions (Se) de largeurs différentes sur une extrémité (2a) d'une ligne de métal (2) serpentant en surface du circuit intégré, sous ladite couche de passivation, à compter le nombre d'impulsions reçues sur l'autre extrémité de la ligne de métal, et à comparer ce nombre (N) à au moins une valeur de référence (Nref) caractéristique du filtre formé par la ligne de métal et la couche de passivation.

2. Procédé selon la revendication 1, caractérisé en ce qu'il consiste à comparer ledit nombre à deux valeurs de référence définissant un intervalle de tolérance.

3. Procédé selon la revendication 1 ou 2, caractérisé en ce que le train d'impulsion est émis séquentiellement sur activation d'un signal binaire qui synchronise la réception.

4. Procédé selon la revendication 3, caractérisé en ce que la séquence d'activation dudit signal binaire est aléatoire.

5. Procédé selon l'une quelconque des revendications précédentes, caractérisé en ce que la comparaison est effectuée par un microprocesseur du circuit intégré qui effectue en outre un filtrage numérique des résultats obtenus.

6. Circuit intégré comprenant un détecteur de présence d'une couche diélectrique de passivation, ledit détecteur comprenant une ligne de métal (2) serpentant en surface du circuit intégré sous la couche de passivation (16), un émetteur (1) d'un train d'impulsions (Se) de largeurs différentes sur une extrémité (2a) de la ligne de métal et un récepteur (3) connecté à l'autre extrémité (2b) de la ligne de métal, ledit récepteur étant apte à compter le nombre d'impulsions reçues et à comparer ce nombre à au moins une valeur de référence caractéristique du filtre formé par la ligne de métal et la couche de passivation.

7. Circuit intégré selon la revendication 6, caractérisé en ce qu'il comprend un comparateur (6) apté à comparer le nombre mesuré à deux valeurs de références définissant un intervalle de tolérance.

8. Circuit intégré selon la revendication 6 ou 7, caractérisé en ce qu'il comprend des éléments de mémoire non volatile pour mémoriser le ou les valeurs de référence.

9. Circuit intégré selon l'une quelconque des revendications 6 à 7, caractérisé en ce qu'il comprend un circuit pour générer séquentiellement un signal binaire appliqué à l'émetteur et au récepteur, pour émettre des trains d'impulsion successivement et effectuer les mesures correspondantes.

10. Circuit intégré selon la revendication 9, caractérisé en ce que ledit circuit pour générer est un générateur aléatoire.

11. Circuit intégré selon l'une quelconque des revendications 9 ou 10, comprenant un microprocesseur, caractérisé en ce que le récepteur comprend un compteur dont la sortie est lue par ledit microprocesseur pour effectuer la comparaison aux valeurs de référence et effectuer un filtrage numérique sur la suite des résultats obtenus.

## Patentansprüche

1. Verfahren zur Erfassung der Anwesenheit einer dielektrischen Passivierungsschicht (16) auf einem integrierten Schaltkreis, das Aussenden einer Impulsfolge (Se) unterschiedlicher Größen auf ein Ende (2a) einer Metalleitung (2), die um die Oberfläche des integrierten Schaltkreises unter der Passivierungsschicht gewickelt ist, das Zählen der Zahl an Impulsen, die am anderen Ende der Metalleitung empfangen werden, und das Vergleichen dieser Zahl (N) mit wenigstens einem Referenzwert (Nref), der typisch für den durch die Metalleitung und die Passivierungsschicht gebildeten Filter ist, umfaßt.

2. Verfahren nach Anspruch 1, dadurch gekennzeichnet, daß es das Vergleichen der Zahl mit zwei Referenzwerten umfaßt, die ein Toleranzintervall definieren.

3. Verfahren nach Anspruch 1 oder 2, dadurch gekennzeichnet, daß die Impulsfolge sequentiell bei Aktivierung eines binären Signals erfolgt, das den Empfang synchronisiert.

4. Verfahren nach Anspruch 3, dadurch gekennzeichnet, daß die Aktivierungssequenz des binären Signals zufällig ist.

5. Verfahren nach einem der vorangehenden Ansprüche, dadurch gekennzeichnet, daß der Vergleich durchgeführt wird durch einen Mikroprozessor des integrierten Schaltkreises, der außerdem eine numerische Filterung der erhaltenen Resultate durchführt.

6. Integrierter Schaltkreis mit einem Detektor für die Anwesenheit einer dielektrischen Passivierungsschicht, wobei der Detektor eine Metalleitung (2), die um die Oberfläche des integrierten Schaltkreises unter der Passivierungsschicht (16) gewickelt ist, einen Sender (1) einer Impulsfolge (Se) unterschiedlicher Größen an einem Ende (2a) der Metalleitung und einen Empfänger (3), der mit dem anderen Ende (2b) der Metalleitung verbunden ist, umfaßt, wobei der Empfänger dazu ausgelegt ist, die Zahl der empfangenen Impulse zu zählen und diese Zahl wenigstens mit einem Referenzwert zu vergleichen, der typisch für den Filter ist, der durch die Metalleitung und die Passivierungsschicht gebildet wird.

7. Integrierter Schaltkreis nach Anspruch 6, dadurch gekennzeichnet, daß er einen Vergleicher (6) umfaßt, der dazu ausgelegt ist, die gemessene Zahl mit zwei Referenzwerten zu vergleichen, die ein Toleranzintervall definieren.

8. Integrierter Schaltkreis nach Anspruch 6 oder 7, dadurch gekennzeichnet, daß er nicht flüchtige Speicherelemente zum Abspeichern des oder der Referenzwerte umfaßt.

9. Integrierter Schaltkreis nach einem der Ansprüche 6 und 7, dadurch gekennzeichnet, daß er einen Schaltkreis zum sequentiellen Erzeugen eines binären Signals umfaßt, das an den Sender und an den Empfänger abgegeben wird, damit Impulsfolgen sukzessiv ausgesendet werden und die entsprechenden Messungen durchgeführt werden.

10. Integrierter Schaltkreis nach Anspruch 9, dadurch gekennzeichnet, daß der Schaltkreis zum Erzeugen ein Zufallsgenerator ist.

11. Integrierter Schaltkreis nach einem der Ansprüche 9 oder 10, der einen Mikroprozessor umfaßt, dadurch gekennzeichnet, daß der Empfänger einen Zähler umfaßt, dessen Ausgang durch den Mikroprozessor ausgelesen wird, um den Vergleich mit den Referenzwerten durchzuführen und nachfolgend eine numerische Filterung der erhaltenen Ergebnisse durchzuführen.

## Claims

1. Method of detecting the presence of a dielectric passivation layer (16) on an integrated circuit, consisting of emitting a train of pulses (Se) of different widths at one end (2a) of a metal line (2) coiled on the surface of the integrated circuit, underneath the said passivation layer, counting the number of pulses received at the other end of the metal line, and comparing this number (N) with at least one reference value (Nref) characteristic of the filter formed by the metal line and the passivation layer.

2. Method according to Claim 2, characterised in that it consists of comparing the said number with two reference values defining a tolerance range.

3. Method according to Claim 1 or 2, characterised in that the pulse train is emitted sequentially on activation of a binary signal which synchronises reception.

4. Method according to Claim 3, characterised in that the sequence of activation of the said binary signal is random.

5. Method according to any one of the preceding claims, characterised in that the comparison is made by a microprocessor of the integrated circuit which also performs a digital filtering of the results obtained.

6. Integrated circuit comprising a detector detecting the presence of a dielectric passivation layer, the said detector comprising a metal line (2) coiled on the surface of the integrated circuit underneath the passivation layer (16), an emitter (1) emitting a train of pulses (Se) of different widths at one end (2a) of the metal line and a receiver (3) connected to the other end (2b) of the metal line, the said receiver being able to count the number of pulses received and to compare this number with at least one reference value characteristic of the filter formed by the metal line and the passivation layer.

7. Integrated circuit according to Claim 6, characterised in that it comprises a comparator (6) able to compare the measured number with two reference values defining a tolerance range.

8. Integrated circuit according to Claim 6 or 7, characterised in that it comprises non-volatile memory elements for storing the reference value or values.

9. Integrated circuit according to either one of Claims 6 to 7, characterised in that it comprises a circuit for sequentially generating a binary signal applied to the emitter and to the receiver, for emitting pulse trains successively and making the corresponding measurements.

10. Integrated circuit according to Claim 9, characterised in that the said circuit for generating is a random generator.

11. Integrated circuit according to either one of Claims 9 or 10, comprising a microprocessor, characterised in that the receiver comprises a counter whose output is read by the said microprocessor for effecting the comparison with the reference values and performing a digital filtering on the sequence of results obtained.
